# FASCICULE DE BREVET EUROPEEN

(11) **EP 2 278 613 B1**
(45) Date de publication et mention de la délivrance du brevet: **05.06.2013**
(21) Numéro de dépôt: 10166935.6
(22) Date de dépôt: 22.06.2010
(51) Int. Cl.: H01L 21/768, H01L 23/48, H01L 25/065

(54) **Via de connexion électrique tubulaire constitué de plusieurs vias conducteurs élémentaires**
Röhrenförmige Durchkontaktierung, welche aus mehreren leitfähigen Einzel-Durchkontaktierungen besteht
Tubular electrical via consisting of a plurality of elementary conductive vias

(30) Priorité: 21.07.2009 FR 0955055
(43) Date de publication de la demande: 26.01.2011
(73) Titulaire: STMicroelectronics (Crolles 2) SAS, 38920 Crolles (FR)
(72) Inventeur: Chaabouni, Hamed, 38000 Grenoble (FR); Cadix, Lionel, 38000 Grenoble (FR)
(74) Mandataire: de Beaumont, Michel

(56) Documents cités:
- EP-A1- 1 427 006
- EP-A1- 1 892 757
- DE-A1- 10 323 394
- FR-A1- 2 901 636
- GB-A- 2 343 298
- US-A1- 2006 043 598
- US-A1- 2007 069 364
- US-A1- 2007 290 300
- US-A1- 2009 014 891
- US-B1- 6 747 352

## Description

### Domaine de l'invention

La présente invention concerne une connexion électrique isolée entre la face avant et la face arrière d'un substrat, couramment désignée dans la technique par le terme via.

### Exposé de l'art antérieur

Parmi les nombreux domaines d'utilisation des vias, on peut citer les dispositifs à empilement de puces. Dans ces dispositifs, on prévoit de superposer des puces ou des tranches semiconductrices, accolées les unes aux autres. Ceci permet d'augmenter les fonctions réalisées par un dispositif sans augmenter la surface occupée.

Dans ces dispositifs, les connexions entre les composants des différents étages peuvent être réalisées soit par des techniques traditionnelles de câblage filaire, soit par des vias traversant le substrat des puces.

Un avantage des vias réside dans la possibilité de les fabriquer collectivement, contrairement aux fils pour lesquels un montage unitaire doit être réalisé. Les autres principaux avantages des vias par rapport aux fils résident dans le gain de surface qu'ils apportent, l'amélioration des performances électriques, et la possibilité de répartition en surface des entrées/sorties. Un autre avantage de la connexion par vias est que ces vias seront couramment réalisés dans des tranches de silicium. Ces tranches de silicium seront ensuite assemblées de diverses manières dont celle décrite ci-après, puis pourront être découpées en puces individuelles. De tels procédés collectifs conduisent à des réductions de coût. Dans la présente description, on mentionnera des assemblages de puces, mais il sera clair que ces puces pourront être des plaques, des tranches semiconductrices ou des éléments de tranches semiconductrices.

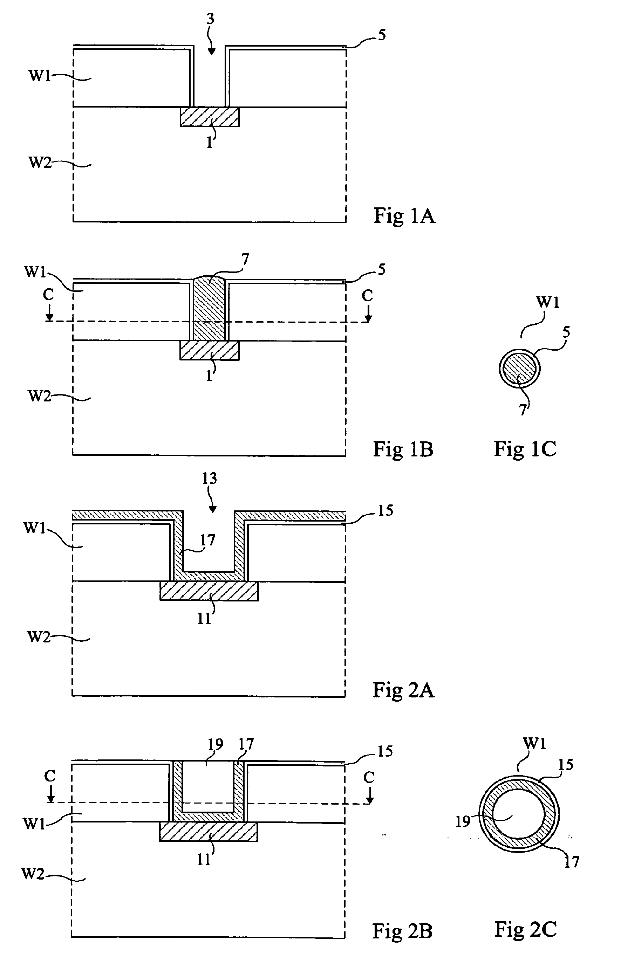

Les figures 1A et 1B sont des vues de côté en coupe illustrant des étapes d'un procédé de réalisation d'un via plein de diamètre inférieur à 10 µm, par exemple de l'ordre de 0,5 à 10 µm. La figure 1C est une vue de dessus en coupe selon le plan C-C de la figure 1B, et représente une section du via réalisé.

Une puce ou tranche semiconductrice amincie W1 est superposée à une puce ou tranche semiconductrice W2. Les puces W1 et W2 sont par exemple collées entre elles par adhérence moléculaire. L'amincissement de la puce W1 peut être réalisé avant ou après le collage. Les puces W1 et W2 sont chacune formées dans un substrat semiconducteur, selon des procédés de réalisation classiques. Elles comportent notamment chacune des zones actives, dans lesquelles sont formés des composants, et un empilement de pistes conductrices d'interconnexion, par exemple des pistes de cuivre, reliant les composants entre eux et aux entrées/sorties. A la surface de la puce W2, du côté de la face commune aux puces W1 et W2, il est prévu un plot de contact conducteur 1, correspondant par exemple à une portion de cuivre d'un niveau d'interconnexion supérieur. Le plot de contact 1 est relié à une borne de la puce par des pistes conductrices non représentées de façon à pouvoir être connecté à un potentiel de référence lors d'une étape ultérieure de dépôt électrolytique.

Un trou 3, traversant de part en part le substrat de la puce W1, est formé en regard du plot de contact 1. Le trou 3 peut être percé par gravure sèche ou gravure chimique. Une isolation des parois du trou 3 est réalisée, par exemple par dépôt d'une couche 5 d'oxyde de silicium. La portion de la couche isolante 5 recouvrant, au fond du trou 3, le plot de contact 1, est retirée pour laisser le plot 1 accessible.

L'assemblage ainsi réalisé est plongé dans une solution électrolytique conductrice adaptée, par exemple de sulfate de cuivre. Le plot de contact 1 est mis à un potentiel négatif et forme une cathode. Une anode de cuivre, reliée à un potentiel positif, est plongée dans la solution électrolytique. Il circule alors un courant entre l'anode et la cathode. Du cuivre se dépose progressivement par électrolyse sur la cathode, venant remplir le trou 3. L'électrolyse est interrompue lorsque le trou 3 est plein, formant ainsi un via cylindrique 7. On peut en outre prévoir une étape de planarisation, pour égaliser la surface du via 7 après l'électrolyse.

Pour des diamètres supérieurs à quelques µm, la formation de vias par électrolyse serait trop longue et trop coûteuse à mettre en oeuvre.

Les figures 2A et 2B sont des vues de côté en coupe illustrant des étapes de réalisation d'un via de diamètre supérieur à 10 µm, par exemple de l'ordre de 10 à 200 µm. La figure 2C est une vue de dessus en coupe selon le plan C-C de la figure 2B, et représente une section du via réalisé.

Des puces ou tranches semiconductrices W1 et W2 sont superposées de la façon décrite ci-dessus. A la surface de la puce W2, du côté de la face commune aux puces W1 et W2, il est prévu un plot de contact conducteur 11, correspondant par exemple à une portion de cuivre d'un niveau d'interconnexion supérieur.

Un trou 13 traversant de part en part la puce W1, est percé en regard du plot 11. Une gaine d'isolation des parois du trou 13 est formée, par exemple par dépôt d'une couche 15 d'oxyde de silicium. La portion de la couche isolante 15 recouvrant le plot de contact 11 est retirée pour laisser le plot 11 accessible.

Une couche conductrice 17, par exemple une couche de cuivre, est formée par dépôt conforme sur les parois isolées et sur le fond du trou 13. La couche 17 forme un contact avec le plot 11 de la puce W2.

Les portions de la couche 17 à la surface de la puce W1 sont retirées pour ne conserver que la partie appliquée sur les parois isolées et sur le fond du trou 13. La partie restante de la couche 17 forme ainsi un via tubulaire 17, ayant en vue de dessus la forme d'un anneau.

Le via 17 est généralement comblé par une résine de remplissage 19.

Des exemples de vias pleins ou tubulaires sont par exemple décrits dans les documents US2007/0290300 et EP1892757. D'autres exemples de vias sont décrits dans les documents US2007/0069364 et US6747352.

On s'intéresse ici aux vias tubulaires, de diamètres de l'ordre de quelques dizaines de µm, du type décrit en relation avec les figures 2A à 2C.

En fonctionnement, lorsque les vias sont parcourus par des courants, ils produisent par effet Joule de la chaleur. Il en résulte une élévation de leur température, pouvant conduire à des dégradations ou à une réduction de la durée de vie des puces.

En outre, sous l'effet des variations de température, la résine de remplissage 19 des vias est susceptible de se déformer et de former des cloques.

### Résumé

Un objet d'un mode de réalisation de la présente invention est de pallier tout ou partie des inconvénients des vias tubulaires classiques.

Un objet d'un mode de réalisation de la présente invention est de proposer une structure de via tubulaire permettant de limiter l'élévation de la température du via lorsqu'il est parcouru par un courant.

Ainsi, un mode de réalisation de la présente invention selon la revendication 1 prévoit un via de connexion électrique reliant la face avant d'un substrat à un unique plot de contact disposé du côté de la face arrière du substrat, ce via comprenant une pluralité de vias conducteurs élémentaires ayant chacun la forme d'une tige cylindrique pleine, les vias élémentaires étant disposés, en coupe dans un plan parallèle aux faces, selon un anneau, le volume compris à l'intérieur du cylindre droit défini par ledit anneau étant constitué du matériau du substrat,

les vias élémentaires étant accolés les uns aux autres en coupe dans un plan parallèle aux faces.

Les revendications dépendantes définissent des modes de réalisation privilégiés de la présente invention.

Selon un mode de réalisation privilégié de la présente invention, les vias élémentaires ont chacun un diamètre compris entre 0,5 et 10 µm.

Selon un mode de réalisation privilégié de la présente invention, le via a un diamètre compris entre 10 et 200 µm.

Selon un mode de réalisation privilégié de la présente invention, les vias élémentaires sont isolés du substrat par un matériau électriquement isolant.

Il est aussi décrit un procédé de réalisation d'un via de connexion électrique reliant la face avant d'un substrat à un unique plot de contact disposé du côté de la face arrière du substrat, ce procédé comportant les étapes suivante :
percer une pluralité de trous traversant le substrat de part en part et reliant la face avant au plot, ces trous étant disposés, en vue de dessus, selon un anneau ; et
remplir lesdits trous d'un matériau conducteur.

Ce procédé peut comporter en outre une étape d'isolation des parois desdits trous avant l'étape de remplissage.

Le remplissage des trous est effectué par dépôt électrolytique, le plot formant une borne d'électrolyse.

### Brève description des dessins

Ces objets, caractéristiques et avantages, ainsi que d'autres seront exposés en détail dans la suite de la description.
Les figures 1A et 1B, précédemment décrites, sont des vues de côté en coupe illustrant des étapes de réalisation d'un via plein de diamètre inférieur à 10 µm ;
la figure 1C, précédemment décrite, est une vue de dessus en coupe de la figure 1B représentant une section d'un via plein ;
les figures 2A et 2B, précédemment décrites, sont des vues de côté en coupe illustrant des étapes de réalisation d'un via tubulaire de diamètre supérieur à 10 µm ;
la figure 2C, précédemment décrite est une vue de dessus en coupe de la figure 2B représentant une section d'un via tubulaire ;
la figure 3A est une vue de côté en coupe illustrant un mode de réalisation d'un via de diamètre supérieur à 10 µm ;
la figure 3B est une vue de dessus en coupe de la figure 3A ; et
la figure 4 est une vue de dessus illustrant un autre via de diamètre supérieur à 10 µm.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

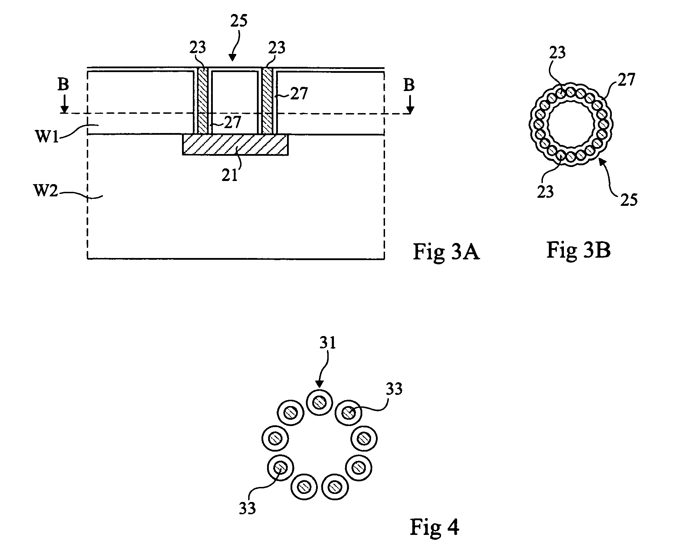

On notera que l'objet des revendications concerne les figures 3A et 3B.

Les inventeurs ont étudié les phénomènes de dissipation de la chaleur produite dans des vias.

Une première partie de la chaleur se propage à partir du haut et du bas des vias vers les pistes d'interconnexion de la puce. Toutefois, la surface de dissipation fournie par les pistes d'interconnexion est faible. En outre, des couches isolantes, généralement d'oxyde de silicium, sont intercalées entre les niveaux d'interconnexion successifs. Il en résulte que la dissipation de chaleur par l'intermédiaire des pistes d'interconnexion est faible.

Une deuxième partie de la chaleur est dissipée, à partir de la surface latérale externe du via, à travers la gaine isolante, dans le corps du substrat. Toutefois, la faible conductivité thermique de la gaine isolante limite la dissipation de chaleur dans le corps du substrat.

On cherche ici à améliorer les échanges thermiques entre un via et le corps du substrat qu'il traverse, de façon à réduire l'élévation de la température du via.

La chaleur produite par effet Joule est directement proportionnelle à la résistance du via. Ainsi, il est bien entendu que les solutions proposées par les inventeurs doivent être comparées aux solutions de l'art antérieur à résistance égale, c'est-à-dire, dans le cas de vias en cuivre de même hauteur, à des vias de même volume.

La figure 3A est une vue de côté en coupe illustrant un mode de réalisation d'un via de diamètre supérieur à 10 µm, par exemple de l'ordre de 10 à 200 µm. La figure 3B est une vue en coupe selon le plan B-B de la figure 3A.

Une puce ou tranche semiconductrice amincie W1 est superposée à une puce ou tranche semiconductrice W2 de la façon décrite en relation avec les figures 1A et 1B. A la surface de la puce W2, du côté de la face commune aux puces W1 et W2, il est prévu un plot de contact conducteur 21, correspondant par exemple à une portion de cuivre d'un niveau d'interconnexion supérieur. Le plot de contact 21 est relié à une borne de la puce par des pistes conductrices non représentées de façon à pouvoir être connecté à un potentiel de référence lors d'une étape d'électrolyse, pendant la fabrication du via.

Plusieurs vias élémentaires cylindriques pleins 23 traversent de part en part le substrat de la puce W1 pour former ensemble un via tubulaire 25. Les vias élémentaires 23 ont un diamètre très inférieur au diamètre du via tubulaire 25. A titre d'exemple, le via tubulaire peut avoir un diamètre de l'ordre de 10 à 200 µm et les vias élémentaires peuvent avoir un diamètre de l'ordre de 1 µm. Les vias élémentaires 23 sont disposés, en vue de dessus, selon un anneau, circulaire dans le cas représenté. Dans l'exemple représenté en figure 3B, les vias élémentaires 23 sont accolés les uns aux autres et forment ensemble un via tubulaire 25 à parois latérales festonnées. Une couche isolante 27, par exemple d'oxyde de silicium, isole le via 25 du substrat.

Dans cet exemple, les vias 23 sont remplis par électrolyse, selon le procédé décrit en relation avec les figures 1A à 1C, à la seule différence qu'au lieu de percer un unique trou dans le substrat, on perce une pluralité de trous accolés disposés en vue de dessus en un anneau de façon à former un tube à parois festonnées. A titre d'exemple, les trous peuvent être réalisés par gravure sèche de type RIE (acronyme des termes Anglo-Saxon "Reactive Ion Etching").

Un avantage du mode de réalisation proposé est que, grâce au festonnage, la surface de contact entre le via et la couche isolante d'oxyde de silicium est augmentée par rapport aux vias tubulaires de l'art antérieur en forme de cylindre droit à section circulaire. Il en résulte une augmentation des échanges thermiques entre le via et le substrat de la puce. Ceci limite l'élévation de température du via et les risques de dégradation associés.

Un autre avantage de la structure proposée est que le volume compris à l'intérieur du tube festonné est constitué du matériau du substrat, couramment du silicium, et non pas d'une résine de remplissage. Ainsi, les variations de contraintes dues aux variations de températures sont les mêmes à l'intérieur et à l'extérieur du via. Il ne se forme donc pas de cloques comme dans le cas des vias classiques.

La figure 4 est une vue de dessus en coupe représentant un autre via de diamètre supérieur à 10 µm, par exemple de l'ordre de 10 à 200 µm. La figure 4 représente une section d'un via selon le même plan que la figure 3B.

Le via 31 est similaire au via 25 des figures 3A et 3B. La seule différence est que les vias élémentaires 33 qui le constituent ne sont pas accolés les uns aux autres. Ainsi, le via 31 a, en vue de dessus, la forme d'un anneau festonné discontinu.

Un mode de réalisation particulier de la présente invention été décrit. Diverses variantes et modifications apparaîtront à l'homme de l'art.

En particulier, les diamètres de via mentionnés dans la description sont uniquement donnés à titre d'exemple. L'homme de l'art saura mettre en oeuvre le fonctionnement recherché pour d'autres diamètres.

En outre, la présente description mentionne des vias et des pistes d'interconnexion en cuivre. Toutefois, l'invention ne se limite pas à ce seul cas particulier. L'homme de l'art saura également mettre en oeuvre le fonctionnement recherché en utilisant d'autres métaux ou matériaux conducteurs, par exemple du silicium polycristallin fortement dopé, pour former la partie conductrice des vias.

De plus, la formation de la structure selon l'invention ne se limite pas aux procédés de formation de la partie conductrice du via par dépôt électrolytique, tel que mentionné ci-dessus. A titre d'exemple, la partie conductrice du via pourra être déposée par voie chimique en phase vapeur de silicium polycristallin. Ce silicium sera fortement dopé pour être rendu conducteur.

De même, l'homme de l'art saura mettre en oeuvre le fonctionnement recherché quels que soient les matériaux isolants utilisés pour former les diverses couches isolantes mentionnées dans la description. En particulier, l'homme de l'art saura avantageusement se passer d'une gaine d'isolation du via dans le cas d'un substrat isolant. Par ailleurs, dans le cas d'un substrat conducteur, pour améliorer d'avantage les échanges thermiques entre un via et le substrat, la gaine pourra être constituée d'un matériau électriquement isolant mais thermiquement conducteur.

De plus, pour améliorer les échanges thermiques, on pourra prévoir un via ayant une surface latérale externe présentant des irrégularités, de façon à augmenter encore la surface de contact entre ce via et la gaine isolante.

## Revendications

1. Via de connexion électrique (25) reliant la face avant d'un substrat (W1) à un unique plot de contact (21) disposé du côté de la face arrière du substrat, comprenant une pluralité de vias conducteurs élémentaires (23) ayant chacun la forme d'une tige cylindrique pleine, dans lequel :
les vias élémentaires sont disposés, en coupe dans un plan parallèle aux faces, selon un anneau ;
le volume compris à l'intérieur du cylindre droit défini par ledit anneau est constitué du matériau du substrat ; et
en coupe dans un plan parallèle aux faces, les vias élémentaires sont accolés les uns aux autres.

2. Via (25) selon la revendication 1, dans lequel les vias élémentaires (23) ont chacun un diamètre compris entre 0,5 µm et 10 µm.

3. Via (25) selon la revendication 1 ou 2, de diamètre compris entre 10 µm et 200 µm.

4. Via (25) selon l'une quelconque des revendications 1 à 3, isolé du substrat (W1) par un matériau électriquement isolant (27).

## Patentansprüche

1. Eine elektrische Durchkontaktierung (VIA) (25) die eine vordere Oberfläche eines Substrats (W1) mit einem einzigen Kontaktanschluss (21) angeordnet auf der Seite der hinteren Oberfläche des Substrats verbindet wobei eine Vielzahl von elementaren leitenden Durchkontaktierungen (23) vorgesehen ist, deren jede die Form eines massiven zylindrischen Stabes aufweist, wobei:
die elementaren Durchkontaktierungen im Querschnitt einer Ebene parallel zu den Oberflächen entsprechend einem Ring angeordnet sind;
das Volumen innerhalb des geraden Zylinders definiert durch den erwähnten Ring aus dem Material des Substrats gemacht ist; und
in einem Querschnitt einer Ebene parallel zu den Oberflächen sind die elementaren Durchkontaktierungen in Kontakt miteinander.

2. Die Durchkontaktierung (25) nach Anspruch 1, wobei die elementaren Durchkontaktierungen (23) jeweils einen Durchmesser besitzen, der im Bereich von 0.5 bis 10 µm liegt.

3. Die Durchkontaktierung (25) nach Anspruch 1 oder 2, mit einem Durchmesser im Bereich zwischen 10 µm und 200 µm.

4. Die Durchkontaktierung (25) nach einem der Ansprüche 1 bis 3, isoliert vom Substrat (W1) durch ein elektrisch isolierendes Material (27).

## Claims

1. An electrical connection via (25) connecting the front surface of a substrate (W1) to a single contact pad (21) arranged on the rear surface side of the substrate, comprising a plurality of elementary conductive vias (23) each having the shape of a solid cylindrical rod, wherein:
the elementary vias are disposed in cross-section in a plane parallel to the surfaces, according to a ring;
the volume comprised inside the right cylinder defined by said ring is made of the material of the substrate; and
in cross-section in a plane parallel to the surfaces, the elementary vias are contacting each other.

2. The via (25) of claim 1, wherein the elementary vias (23) each have a diameter ranging between 0.5 and 10 µm.

3. The via (25) of claim 1 or 2, having a diameter ranging between 10 µm and 200 µm.

4. The via (25) of any of claims 1 to 3, insulated from the substrate (W1) by an electrically-insulating material (27).
